# EUROPEAN PATENT SPECIFICATION

(11) **EP 0 240 299 B1**
(45) Date of publication and mention of the grant of the patent: **22.06.1994**
(21) Application number: 87302771.8
(22) Date of filing: 31.03.1987
(51) Int. Cl.: H04L 7/02

(54) **Bit synchronization circuit**
Bitsynchronisierungsschaltung
Circuit de synchronisation de bit

(30) Priority: 31.03.1986 JP 74022/86
(43) Date of publication of application: 07.10.1987
(73) Proprietor: NEC CORPORATION, Tokyo (JP)
(72) Inventor: Oyagi, Takashi c/o NEC Corporation, Minato-ku Tokyo 108-01 (JP); Yoshizawa, Shigeo c/o NEC Corporation, Minato-ku Tokyo 108-01 (JP)
(74) Representative: Orchard, Oliver John

(56) References cited:
- WO-A-85/02961
- US-A- 4 400 817

## Description

### BACKGROUND OF THE INVENTION

The present invention relates to a bit synchronization circuit for regenerating clock signals synchronized with a received digital signal and, more particularly, to a bit synchronization circuit for regenerating a synchronized clock signal by variable frequency division of an original clock signal so as to synchronize with the received digital signal.

A bit synchronization circuit of this kind of the prior art regenerates a synchronized clock by extracting the transition point of a received digital signal and so increasing or decreasing the frequency division ratio of a variable frequency divider as to synchronize the transition point with the trailing edge (or leading edge) of the regenerated synchronized clock. In this case, the control of the variable frequency divider is effected for each bit of the received digital signal.

In such a bit synchronization circuit of the prior art, because it operates for each bit of the received digital signal, the progress and delay of the regenerated clock signal are alternately detected on a bit-by-bit basis when the duty ratio of the received digital signal is unfavorable, i.e., other than 50 percent. Therefore, the phase of the regenerated clock signal is not adjusted while the frequency division ratio of the frequency divider is changed on the basis of the detected information.

In international patent application number PCT/US84/01950 published on July 4 1985 under publication number WO 85/02961, there is described an automatic clock recovery circuit which samples a received data signal with a recovered clock signal and advances or retards the recovered clock signal only when the received data signal has a particular duty cycle ratio.

A feature of the present invention, is the provision of a bit synchronization circuit capable of phase adjustment even when the duty ratio of the received signal is unbalanced.

In an embodiment to be described, there is provided a bit synchronization circuit for regenerating a synchronized clock signal synchronized with a received digital signal, comprising: a phase monitoring circuit for detecting bit by bit the phase progress or delay of the synchronized clock signal with respect to the digital signal to supply a phase difference signal; and a phase control circuit responsive to the phase difference signal for adjusting bit by bit the phase of the synchronized clock signal so as to synchronize it with the digital signal, wherein the phase adjustment of the phase control circuit includes no transition between progress and delay adjustments.

Circuit arrangements for use in carrying out the invention will now be described, by way of example, with reference to the accompanying drawings, wherein:-
FIG. 1 shows a schematic block diagram of a preferred embodiment of a bit synchronization circuit according to the present invention;
FIG. 2 is a schematic diagram showing a phase control circuit in the bit synchronization circuit shown in FIG. 1;
FIG. 3 shows a time chart for explaining the operation of the circuit shown in FIG. 2;
FIGS. 4A and 4B are state transition diagrams of bit synchronization circuits of the prior and the present invention, respectively;
FIG. 5 is a diagram schematically showing a phase monitoring circuit in the bit synchronization circuit shown in FIG. 1;
FIG. 6 shows a time chart for explaining the operation of the circuit shown in FIG. 5; and
FIGS. 7A and 7B are time charts showing the phase adjusting operations of the bit synchronization circuit of the prior and the present invention, respectively.

### DETAILED DESCRIPTION OF THE PREFERRED EMBODIMENT

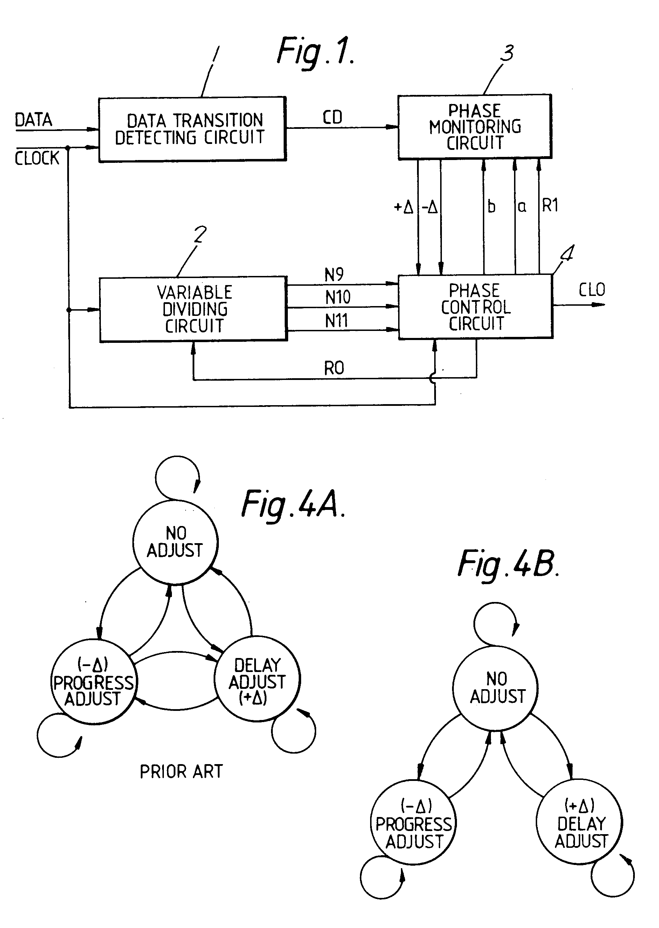

Referring to FIG. 1, a data transition detecting circuit 1 generates a positive pulse at every leading or trailing transitional point of received digital signal DATA. For this purpose, the received digital signal DATA and a clock signal are supplied as input signals. Detecting circuit 1, as is well known, may be composed of an exclusive OR circuit (ExOR) for receiving the digital signal DATA and another signal obtained by delaying this digital signal by a prescribed length of time and a D-type flip-flop for latching the output of this ExOR and outputting detection signal CD. In this instance, the ExOR and the delay circuit function as a differentiating circuit.

A variable frequency dividing circuit 2 is supplied with a clock signal as its input signal, and outputs a signal resulting from frequency division of the input clock signal. In this particular embodiment the dividing circuit 2 provides a divided-by-10 signal as standard, together with divided-by-9 and divided-by-11 signals for phase adjustment. Frequency-divided signals N9 to N11 are signals which are at a high level in the active state (active-high signals). Variable frequency dividing circuit 2 may as well be composed of a well known cascade connection of flip-flops, and frequency-divided signals N9 to N11 are taken out of their intermediate stages. Frequency dividing circuit 2 is reset by a reset pulse R0 supplied at half-bit intervals, which will be described later.

A phase monitoring circuit 3, as will be described in detail below, receives the output signal CD of data transition detecting circuit 1, signals a and b, to be described later, from a phase control circuit 4, and a reset pulse R1 indicating the bit cycle. The circuit 3 determines according to the received signals the progress or delay of the phase of a synchronized clock signal with respect to the transition signal CD, and provides a phase signal -Δ representative of the progress and +Δ representative of the delay at every bit cycle. A phase control circuit 4, on the basis of phase signals -Δ and +Δ from phase monitoring circuit 3, selects at every bit one of frequency division output signals N9 to N11 from frequency dividing circuit 2, and whereby adjusts the phase of the synchronized clock to be synchronized with the received digital signal DATA. The selection out of signals N9 to N11 also depends on the basis of the adjustment of the immediately preceding bit.

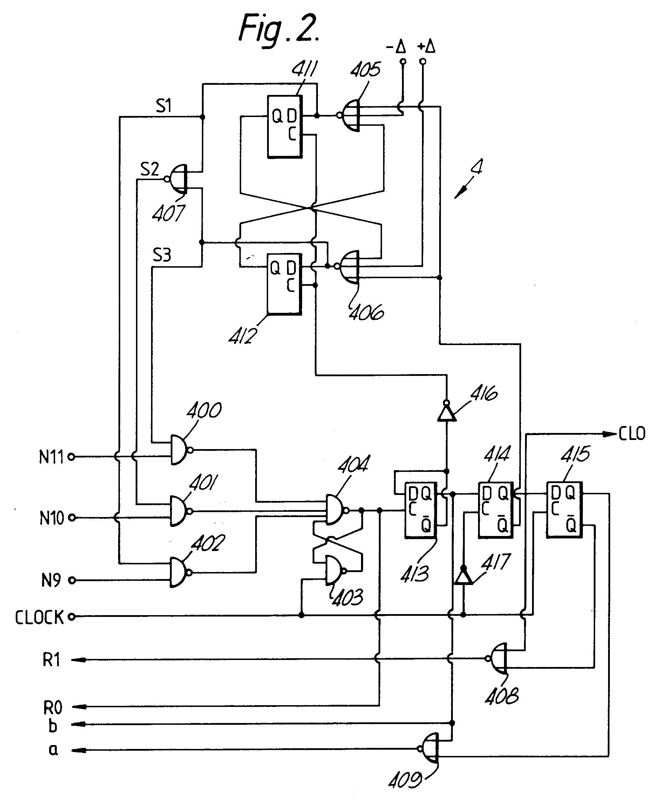

FIG. 2 illustrates a specific example of phase control circuit 4 in FIG. 1. This circuit comprises two-input NAND gates 400 to 403, three-input NAND gate 404, three-input NOR gates 405 and 406, two-input NOR gates 407 to 409, D-type flip-flops (F/Fs) 411 to 416, and inverter gates 416 and 417.

NAND gates 400 to 402 are gates for selecting one of frequency division output signals N9 to N11 of variable frequency dividing circuit 2, and the selected signal is supplied to a set-reset (S-R) F/F comprising gates 403 and 404. NAND gate 404 supplies as its output a positive pulse at every half bit. This output signal is inputted to the clock terminal of D-type F/F 413, and a divided-by-two signal obtained from the Q output terminal thereof is outputted as a synchronized clock signal CL0 through D-type F/F 414. In response to the signal CLO, D-type F/F 415 provides at the Q and Q̅ terminals thereof a signal delayed by a half clock bit from the signal CLO, and a reversed signal, respectively. From the signal CLO and the reversed signal, NOR gate 408 generates a reset signal R1 and supplies it to the phase monitoring circuit 3.

NOR gates 405 to 407 generate, based on the phase signals -Δ and +Δ provided from phase monitoring circuit 3, gate signals S1 to S3 for selecting one of frequency-divided signals N9 to N11. These signals S1 to S3 are active-high signals. Phase signals -Δ and +Δ are active-low signals, which are at a low level in the active state. When the Q̅ output of D-type F/F 414 is at a low level, the gates 405 and 406 are activated. In this state, when the Q outputs of D-type F/Fs 411 and 412 are at a low level, one of signals S1 to S3 is in the active state in accordance with the phase signals -Δ and +Δ. Thus, the signals S1 to S3 are supplied in accordance with the following logic Table 1, though the Q outputs of D-type F/Fs 411 and 412 in this case are are logic "0".

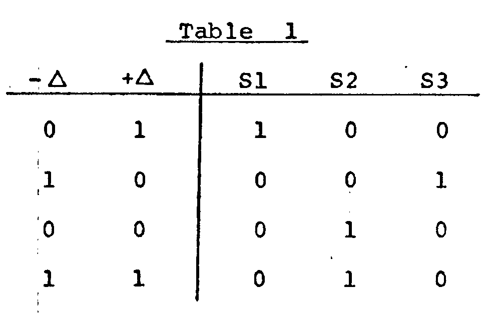

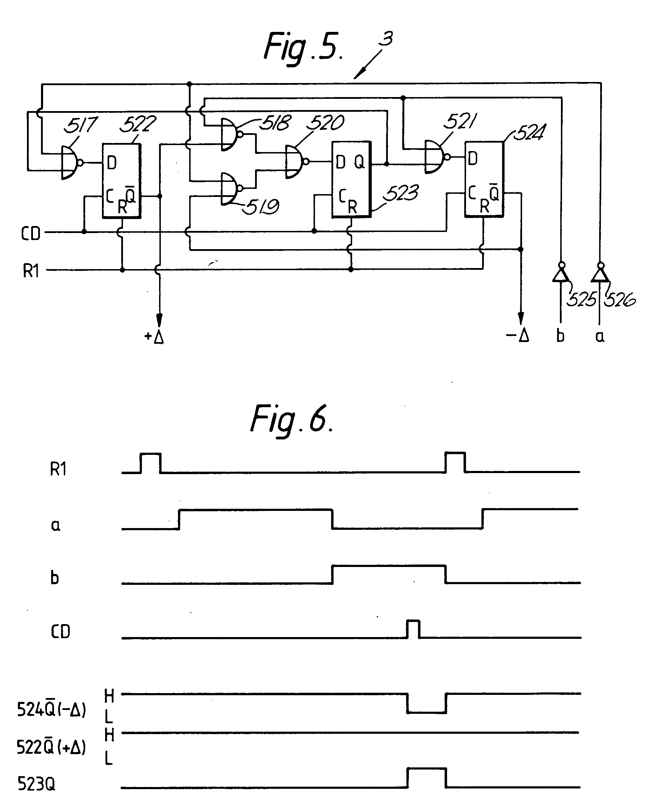

The signals S1 and S3 are latched, with the output of inverter gate 416 as clock input, into D-type F/Fs 411 and 412, whose Q outputs are supplied to NOR gates 405 and 406, respectively, which are reverse in phase. As a result, at the bit next to the selection of signal S1, NOR gate 406 is closed, and signal S3 is not selected. This fact indicates the following. Thus, as shown in FIG. 4B, in the bit synchronization circuit according to the present invention, the path between the progress and delay adjustments is prohibited, so that the phase of the regenerated clock signal can be adjusted even when the duty ratio of the received digital signal is unfavorable. By contrast, in the prior art arrangement of FIG. 4A, on account of the presence of a path between the progress and delay adjustments, no phase adjustment is possible, as stated earlier, when the duty ratio of the received digital signal is unfavorable.

D-type F/Fs 411 and 412 latch or store the adjusting operation at the immediately preceding bit, and do not make adjustment in the reverse direction at the next bit. Thus, if progress is adjusted at the preceding bit, no adjustment of delay is made at the next bit or, conversely, if delay is adjusted at the preceding bit, no adjustment of progress is made at the next bit. This operation is achieved by feeding back the Q terminal outputs of D type F/Fs 411 and 412 to NOR gates 406 and 405, respectively.

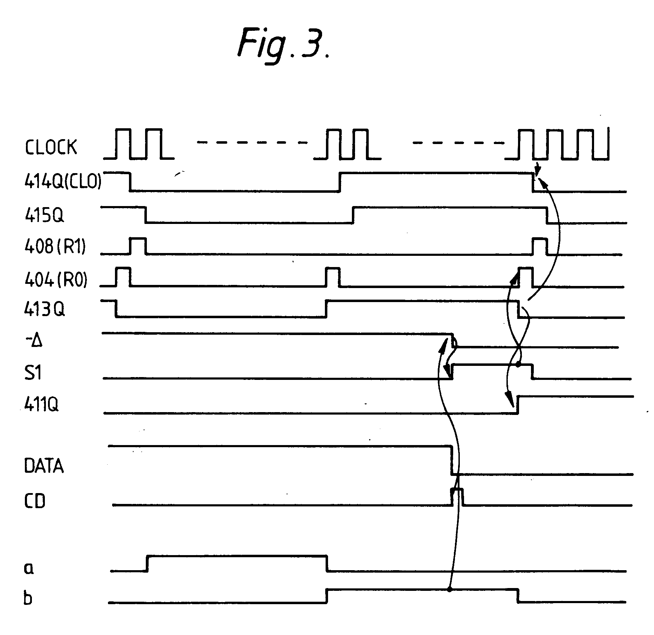

The operation of the circuit of FIG. 2 will be further described with reference to the time chart of FIG. 3, which shows a case in which the regenerated clock signal CLO is ahead of the received digital signal DATA. At a transition point of received digital signal DATA, the detection signal CD is outputted from the data transition detecting circuit 1 (see DATA and CD lines in Fig. 3). The phase monitoring circuit 3, receiving this signal CD and signals a and b obtained from the phase control circuit 4, supplies the phase signal -Δ to adjust progress (see a, b and -Δ lines). Receiving this phase signal -Δ, the phase control circuit 4 makes the selection signal S1 a high level (see S1 line). In response to this selection signal S1, NAND gate 402 selects frequency division output signal N9, and so adjusts the synchronized clock signal CLO as to delay its phase by one original clock with S-R F/Fs 403 and 404 and D-type F/Fs 413 and 414 (see 404(R0), 413Q, 411Q, 414Q(CLO) and CLOCK lines).

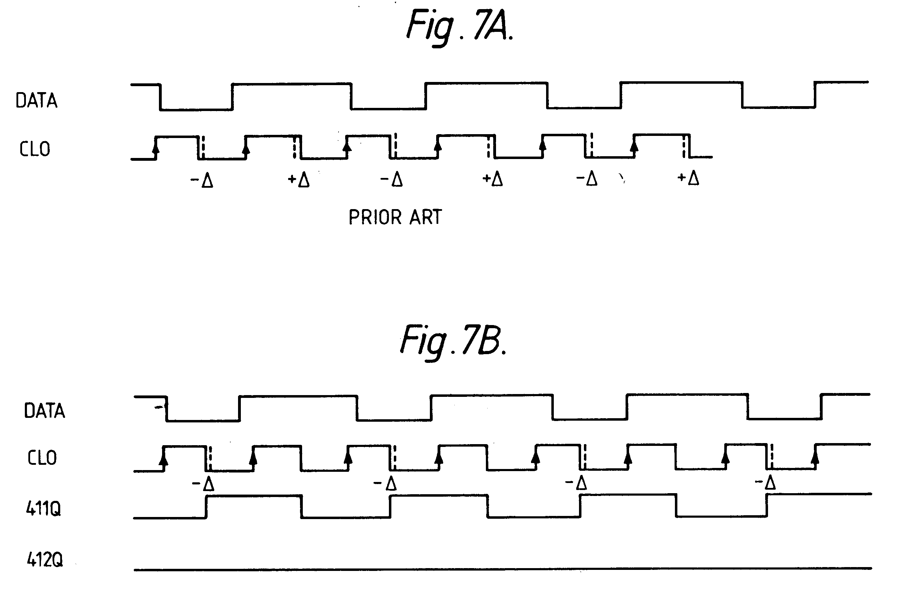

FIGS. 7A and 7B are time charts comparatively showing synchronized clock signals obtained by a bit synchronization circuit of the prior art and one of the present invention. When the duty ratio of received digital signal DATA is unfavorable, in the prior art, the adjusting operation for progress and delay with respect to the signal DATA is alternately repeated at each bit, as shown in FIG. 7A. This results in that the phase difference between the synchronized clock signal CLO and the signal DATA is not adjusted. By contrast, in the bit synchronization circuit according to the present invention, where no state transition takes place between the phase adjustments for progress and delay as stated above, the phase difference of synchronized clock signal CLO with respect to signal DATA is gradually adjusted as shown in FIG. 7B.

FIG. 5 illustrates a specific example of the phase monitoring circuit 3 in FIG. 1. This circuit comprises two-input NOR gates 517 to 521, D-type F/Fs 522 to 524 and inverter gates 525 and 526. The operation of this phase monitoring circuit 3 will now be described with reference to the time chart of FIG. 6.

In response to a bit-by-bit reset signal R1 from phase control circuit 4, D-type F/Fs 522 to 524 are initialized. The phase monitoring is achieved with output signals a and b from phase control circuit 4 and the output signal CD from data transition detecting circuit 1. Thus, if the signal CD is outputted when signal b in FIG. 6 is at a high level, a high level signal is latched through NOR gate 521 at D-type F/F 524, from whose Q̅ output terminal is supplied an active-low phase signal -Δ. Similarly, if the signal CD is outputted when signal a is at a high level, D-type F/F 522 latches a high level signal from NOR gate 517, and from its Q̅ terminal is supplied an active-low phase signal +Δ.

To describe in further detail, the signals a and b from phase control circuit 4 are signals representing the first and second halves, respectively, of one bit of synchronized clock signal CLO. Therefore, the phase monitoring circuit 3 decides whether the transition point signal CD of digital signal DATA is present at the active-high condition of signal a or signal b, or at neither. Thus if the signal CD is present when signal a is active, the synchronized clock signal CLO is determined to be behind the digital signal DATA, and the signal +Δ for delay adjustment is outputted. Conversely, if the signal CD is present when signal b is active, it is judged to be ahead, and the signal -Δ for progress adjustment is outputted.

D-type F/F 523 is used not to execute the phase adjustment when two or more signals CD are present in one data bit. Thus, upon the second generation of signal CD in one data bit, the Q̅ terminal outputs of D-type F/Fs 522 and 524 rise to a high level. This D-type F/F 523 functions to improve the anti-noise performance.

As hitherto described, the bit synchronization circuit according to the present invention forbids the phase adjustment of synchronized clock signals between progress and delay. Therefore, even when the duty ratio of received digital signals is unfavorable, the phase difference between the received digital signal and the regenerated clock signal is gradually adjusted. Received digital signals can be properly sampled according to thereby obtained synchronized clocks, resulting in improvement of reception performance and reliability of digital signals.

## Claims

1. A synchronization circuit for synchronizing a clock signal to a received digital signal, including a phase monitoring circuit (3) for detecting the advance or the delay of the phase of a clock signal with respect to a received digital signal and for producing a phase signal indicative of any advance or delay, characterised in that the synchronization circuit further includes a phase control circuit (4), responsive to the phase signal and irrespective of the duty cycle ratio of the digital signal, for selectively adjusting the phase of the clock signal by either advancing, delaying or leaving unchanged the phase of the clock signal with respect to the digital signal, and in that the phase control circuit (4) includes inhibiting means (405-407, 411,412) for inhibiting the phase control circuit (4) from advancing the phase of the clock signal if the phase has been delayed during an immediately preceding bit period, or from delaying the phase if the phase has been advanced during an immediately preceding bit period, whereby the phase control circuit causes the phase of the clock signal to remain unchanged for at least one bit period before a change in the sense of the phase adjustment is effected.

2. A synchronization circuit as claimed in claim 1, further including edge detecting means (1) for detecting one edge of two signal edges associated with each bit of the digital signal, the two signal edges including a leading edge and a trailing edge, and for outputting an edge indicating signal in response to the detection of the one edge, a frequency dividing circuit (2) for outputting first, second and third frequency-divided clock signals, a frequency-divided clock signal being obtained from an original clock signal, the frequency of which has been respectively divided by first, second and third distinct division values, the phase control circuit (4) including means (403, 404, 408, 409, 413-415, 417) for supplying first and second control signals, the first and second control signals being respectively representative of a first and a second half-bit period of the clock signal, the phase monitoring circuit (3) including decision means (517-526) for determining the location of the edge indicating signal relative to the first and second control signals and for outputting the phase signal in a form which indicates whether the phase of the clock signal is to be advanced, delayed or left unchanged, and the phase control circuit (4) further including means (405-407, 411, 412) for latching the phase signal from the decision means (517-526) during each bit period and for selecting one of the first, second or third frequency-divided clock signals for, respectively, advancing, leaving unchanged, or delaying the phase of the clock signal, in response to the state of the phase signal during both the present and the immediately preceding bit period of the received digital signal.

3. A method of synchronizing a clock signal to a received digital signal, including the steps of detecting a phase relationship between a clock signal and a digital signal during each bit period associated with the digital signal, providing a phase signal which is indicative of whether the clock signal is advanced, delayed or substantially in synchronism with respect to the digital signal, adjusting the phase of the clock signal in response to the phase signal and irrespective of the duty cycle ratio of the digital signal, in a manner which tends to synchronize the clock signal with the digital signal, and controlling the phase adjustment so that the sense of the phase adjustment is not reversed in adjacent bit periods associated with the digital signal.

4. A method as in claim 3, further including the steps of detecting the occurrence of a signal edge of the digital signal during each bit period, determining the state of the phase relationship during the occurrence of the signal edge and producing the phase signal based on the phase relationship, dividing the frequency of an original clock signal by a plurality of different values to supply a plurality of distinct frequency-divided clock signals of different frequencies, latching the phase signal during each bit period of the digital signal, selecting one of the frequency-divided clock signals on the basis of the state of the phase signal during both the present and an immediately preceding bit period, and adjusting the phase of the clock signal by synchronizing the phase thereof to the phase of the selected frequency-divided clock signal.

## Patentansprüche

1. Synchronisierungsschaltung zum Synchronisieren eines Taktsignals mit einem empfangenen Digitalsignal, mit einer Phasenüberwachungszchaltung (3) zum Detektieren des Vorlaufs oder der Verzögerung der Phase eines Taktsignals in bezug auf ein empfangenes Digitalsignal und zum Erzeugen eines Phasensignals, das jeglichen Vorlauf oder jegliche Verzögerung anzeigt, dadurch gekennzeichnet, daß die Synchronisierungsschaltung ferner eine Phasensteuerungsschaltung (4) aufweist, die auf das Phasensignal anspricht und unabhängig ist vom Tastverhältnis des Digitalsignals, zum selektiven Abgleichen der Phase des Taktsignals entweder durch Vorlaufenlassen, Verzögern oder Unverändertlassen der Phase des Taktsignals in bezug auf das Digitalsignal und daß die Phasensteuerungsschaltung (4) eine Sperreinrichtung (405 bis 407, 411, 412) aufweist, um zu verhindern, daß die Phasensteuerungsschaltung (4) die Phase des Taktsignals vorlaufen läßt, wenn die Phase während einer unmittelbar vorausgehenden Bitperiode verzögert worden ist, oder die Phase verzögert, wenn die Phase während einer unmittelbar vorausgehenden Bitperiode einen vorlauf erfahren hat, wobei die Phasensteuerungsschaltung bewirkt, daß die Phase des Taktsignals für mindestens eine Bitperiode unverändert bleibt, bevor eine Änderung in der Richtung der Phasenabgleichung wirksam wird.

2. Synchronisierungsschaltung nach Anspruch 1, ferner mit einer Flankendetektiereinrichtung (1) zum Detektieren einer Flanke von zwei Signalflanken, die zu jedem Bit des Digitalsignals gehören, wobei die beiden Signalflanken eine Vorder- und eine Hinterflanke aufweisen, und zum Ausgehen eines Flankenanzeigesignals als Antwort auf die Detektierung der einen Flanke, einer Frequenzteilungsschaltung (2) zum Ausgeben eines ersten, zweiten und dritten frequenzgeteilten Taktsignals, wobei ein frequenzgeteiltes Taktsignal aus einem ursprünglichen Taktsignal gewonnen wird, dessen Frequenz jeweils durch den ersten, zweiten und dritten unterschiedlichen Teilungswert geteilt wird, wobei die Phasensteuerungsschaltung (4) Einrichtungen (403, 404, 408, 409, 413 bis 415, 417) aufweist zum Bereitstellen eines ersten und eines zweiten Steuersignals, wobei das erste und das zweite Steuersignal jeweils einer ersten und einer zweiten Halbbit-Periode des Taktsignals entsprechen, die Phasensteuerungsschaltung (3) eine Entscheidungseinrichtung (517 bis 526) aufweist zum Bestimmen der Lage des Flankenanzeigesignals relativ zu dem ersten und dem zweiten Steuerungssignal und zum Abgeben des Phasensignals in einer Form, die anzeigt, ob die Phase des Taktsignals zum Vorlaufen gebracht, verzögert oder unverändert gelassen wird, und die Phasensteuerungsschaltung (4) ferner Einrichtungen (405 bis 407, 411, 412) aufweiSt zum Speichern des Phasensignals aus der Entscheidungseinrichtung (517 bis 526) während jeder Bitperiode und zum Wählen des ersten oder des zweiten oder des dritten frequenzgeteilten Taktsignals zwecks Vorlaufenlassens, Unverändertlassens bzw. Verzögerns der Phase des Taktsignals als Antwort auf den Zustand des Phasensignals sowohl während der gegenwärtigen als auch der unmittelbar vorausgehenden Bitperiode des empfangenen Digitalsignals.

3. Verfahren zum Synchronisieren eines Taktsignals mit einem empfangenen Digitalsignal, mit den Schritten: Detektieren einer Phasenbeziehung zwischen einem Taktsignal und einem Digitalsignal während jeder zum Digitalsignal gehörenden Bitperiode, Bereitstellen eines Phasensignals, das anzeigt, ob das Taktsignal in bezug auf das Digitalsignal Vorlauf hat oder verzögert ist oder im wesentlichen synchron ist, Abgleichen der Phase des Taktsignals als Antwort auf das Phasensignal und unabhängig vom Tastverhältnis des Digitalsignals in einer Weise, die dahin tendiert, das Taktsignal mit dem Digitalsignal zu synchronisieren, und Steuern der Phasenabgleichung, so daß die Richtung der Phasenabgleichung nicht in angrenzenden, zu dem Digitalsignal gehörenden Bitperioden umgekehrt wird.

4. Verfahren nach Anspruch 3, ferner mit den Schritten: Detektieren des Auftretens einer Signalflanke des Digitalsignals während jeder Bitperiode, Bestimmen des Zustands der Phasenbeziehung während des Auftretens der Signalflanke und Erzeugen des Phasensignals auf der Grundlage der Phasenbeziehung, Teilen der Frequenz eines ursprünglichen Taktsignals durch eine Anzahl von verschiedenen Werten, um eine Anzahl von unterschiedlichen frequenzgeteilten Taktsignalen mit verschiedenen Frequenzen bereitzustellen, Speichern des Phasensignals während jeder Bitperiode des Digitalsignals, Wählen eines der frequenzgeteilten Taktsignale auf der Grundlage des Zustands des Phasensignals während sowohl der gegenwärtigen als auch der unmittelbar vorausgehenden Bitperiode, und Abgleichen der Phase des Taktsignals durch Synchronisieren der Phase mit der Phase des gewählten frequenzgeteilten Taktsignals.

## Revendications

1. Circuit de synchronisation pour synchroniser un signal d'horloge sur un signal numérique reçu, comportant un circuit de surveillance de phase 3 pour détecter l'avance ou le retard de la phase d'un signal d'horloge par rapport à un signal numérique reçu et pour produire un signal de phase représentatif de tout avance ou retard quelconque, caractérisé en ce que le circuit de synchronisation comporte de plus un circuit de commande de phase (4) sensible au signal de phase et ne tenant pas compte du rapport cyclique du signal numérique, pour ajuster sélectivement la phase du signal d'horloge, soit en avançant, soit en retardant, soit en laissant non changée la phase du signal d'horloge par rapport au signal numérique, et en ce que le circuit de commande de phase (4) comporte un moyen d'interdiction (405 à 407, 411 à 412) pour interdire que le circuit de commande de phase puisse avancer la phase du signal d'horloge si la phase a été retardée pendant une période de bit immédiatement précédente, ou retarder la phase si la phase a été avancée pendant une période de bit immédiatement précédente, d'où il résulte que le circuit de commande de phase amène la phase du signal d'horloge à rester non changée pendant au moins une période de bit avant qu'un changement dans le sens de l'ajustement de phase soit effectué.

2. Circuit de synchronisation selon la revendication 1, comportant de plus, un moyen de détection de front (1) pour détecter un front des deux fronts du signal associé à chaque bit du signal numérique, les deux fronts du signal comportant un front montant et un front descendant, et pour sortir un signal d'indication de front en réponse à la détection de l'un des fronts, un circuit de division en fréquence (2) pour sortir des premier, second et troisième signaux d'horloge divisés en fréquence, un signal d'horloge divisé en fréquence étant obtenu à partir d'un signal d'horloge d'origine, dont la fréquence a été respectivement divisée par des première, seconde et troisième valeurs de division distinctes, le circuit de commande de phase (4) comportant un moyen (403, 404, 408, 409, 413 à 415, 417) pour délivrer des premier et second signaux de commande, les premier et second signaux de commande étant respectivement représentatifs d'une première et d'une seconde période de demi-bit du signal d'horloge, le circuit de surveillance de phase 3 comportant un moyen de décision (517 à 526) pour déterminer l'emplacement du signal indiquant le front par rapport aux premier et second signaux de commande pour sortir le signal de phase sous une forme qui indique si la phase du signal d'horloge doit être avancée, retardée ou laissée non changée, et le circuit de commande de phase (4) comporte de plus un moyen (405 à 407, 411 à 412) pour mémoriser le signal de phase provenant du moyen de décision (517 à 526) pendant chaque période de bit et pour sélectionner un signal parmi les premier, second et troisième signaux d'horloge divisés en fréquence pour, respectivement, avancer, retarder ou laisser non changé la phase du signal d'horloge, en réponse à l'état du signal de phase pendant à la fois la période de bit présente et la période de bit immédiatement précédente du signal numérique reçu.

3. Procédé pour synchroniser un signal d'horloge sur un signal numérique reçu, comportant les étapes consistant à détecter la relation de phase entre un signal d'horloge et un signal numérique pendant chaque période de bit associée au signal numérique, délivrer un signal de phase qui est représentatif du fait que le signal d'horloge est en avance, en retard ou pratiquement en synchronisme par rapport au signal numérique, ajuster la phase du signal d'horloge en réponse au signal de phase et en ne tenant pas compte du rapport cyclique du signal numérique, d'une manière qui tend à synchroniser le signal d'horloge avec le signal numérique, et commander l'ajustement de phase de sorte que le sens de l'ajustement de phase n'est pas inversé dans des périodes de bits contigues associées au signal numérique.

4. Procédé selon la revendication 3, comportant de plus les étapes consistant à détecter la présence d'un front du signal du signal numérique pendant chaque période de bit, déterminer l'état de la relation de phase pendant la présence du front du signal et produire le signal de phase basé sur la relation de phase, diviser la fréquence d'un signal d'horloge d'origine par une multitude de valeurs différentes afin de délivrer une multitude de signaux d'horloge à fréquences divisées distinctes de fréquences différentes, mémoriser le signal de phase pendant chaque période de bit du signal numérique, sélectionner un signal parmi les signaux d'horloge divisés en fréquence sur la base de l'état du signal de phase pendant à la fois la période de bit présente et la période de bit immédiatement précédente, et ajuster la phase du signal d'horloge en synchronisant sa phase avec la phase du signal d'horloge divisé en fréquence sélectionnée.
